# EUROPEAN PATENT SPECIFICATION

(11) **EP 0 684 524 B1**
(45) Date of publication and mention of the grant of the patent: **15.10.2003**
(21) Application number: 95201164.1
(22) Date of filing: 08.05.1995
(51) Int. Cl.: G03F 7/30, G03F 7/07, G03D 5/04

(54) **Method and apparatus for making a lithographic offset plate by the silver salt diffusion transfer process**
Verfahren und Vorrichtung zur Herstellung einer lithographischen Offsetdruckplatte nach dem Silbersalz-Diffusionsübertragungsverfahren
Procédé et dispositif pour la fabrication d'une plaque d'impression lithographique offset suivant le procédé de diffusion-transfert de sel d'argent

(30) Priority: 25.05.1994 EP 94201473
(43) Date of publication of application: 29.11.1995
(73) Proprietor: AGFA-GEVAERT, 2640 Mortsel (BE)
(72) Inventor: Verlinden, Bartholomeus, c/o Agfa-Gevaert N.V., B-2640 Mortsel (BE); Vackier, Bert, c/o Agfa-Gevaert N.V., B-2640 Mortsel (BE); Claes, Jan, c/o Agfa-Gevaert N.V., B-2640 Mortsel (BE); Verhoest, Bart, c/o Agfa-Gevaert N.V., B-2640 Mortsel (BE)

(56) References cited:
- EP-A- 0 410 500
- EP-A- 0 475 384
- EP-A- 0 594 895
- US-A- 4 081 577
- US-A- 4 359 279
- US-A- 4 853 727
- US-A- 5 075 711

## Description

### FIELD OF THE INVENTION

The present invention relates to an apparatus and a method for the processing of photographic sheet materials and particularly for processing such materials according to the silver salt diffusion transfer process for producing a lithographic offset printing plate.

### BACKGROUND OF THE INVENTION

The principles of the silver complex diffusion transfer reversal process, hereinafter called DTR-process, have been described e.g. in US-P-2,352,014 and in the book "Photographic Silver Halide Diffusion Processes" by André Rott and Edith Weyde - The Focal Press - London and New York, (1972).

In the DTR-process non-developed silver halide of an informationwise exposed photographic silver halide emulsion layer material is transformed with a so-called silver halide solvent into soluble silver complex compounds which are allowed to diffuse into an image receiving element and are reduced therein with a developing agent, generally in the presence of physical development nuclei, to form a silver image having reversed image density values with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background.

The DTR-image can be formed in the image receiving layer of a sheet or web material which is a separate element with respect to the photographic silver halide emulsion material (a so-called two-sheet DTR element) or in the image receiving layer of a so-called single-support-element, also called mono-sheet element, which contains at least one photographic silver halide emulsion layer integral with an image receiving layer in waterpermeable relationship therewith. It is the latter mono-sheet version which is preferred for the preparation of offset printing plates by the DTR method.

Two types of the mono-sheet DTR offset imaging elements exist. According to a first type disclosed in e.g. US-P-4,722,535 and GB- 1,241,661 a support is provided in the order given with a silver halide emulsion layer and a layer containing physical development nuclei serving as the image-receiving layer. After informationwise exposure and development, the imaged element is used as a printing plate without the removal of the emulsion layer.

According to a second type of mono-sheet DTR offset imaging element a hydrophillic support, mostly anodized aluminium, is provided in the order given with a layer of physical development nuclei and a silver halide emulsion layer. After informationwise exposure and development, the imaged element is washed with water to remove the emulsion layer so that a support carrying a silver image is left which is used as a printing plate. Such type of lithographic printing plate is disclosed e.g. in US-P-3,511,656.

EP-0 410 500 discloses an imaging element containing a support provided with an image receiving layer and a silver halide emulsion. In said document is disclosed a diffusion transfer reversal process for obtaining a lithographic printing plate in which said imaging element is imagewise exposed and subsequently developed using a developing liquid or activating liquid in the presence of a silver halide complexing agent. The imaging element is then guided through a diffusion transfer zone so that the silver halide complexes formed during the development step are allowed to diffuse into the image receiving layer where they are converted to silver. When the imaging element leaves the diffusion transfer zone a silver image is formed in the image receiving layer. Hereafter, the imaging element passes a washing and a rinsing station to remove the silver halide emulsion layer so that the silver image is exposed. Finally the imaging element, now carrying a silver image on its surface, is treated with a finishing liquid that contains a so called hydrophobizing agent for improving the hydrophobicity of the silver image.

However, said washing requires several precautions, as e.g. a gently or softly washing of the developed monosheet layer assemblage alone is not sufficient to remove the now superfluous emulsion layers from the imaging element, but a certain mechanical force is required.

Therefor, sometimes brushes, sponges, scrapers or squeegee blades, wiping or scrubbing rollers, etc are applied -either individually or separately, or in combination together-, but these elements can damage the image, especially in case of high resolution images.

According to the state of the art relating to the present invention, several attempts have been made of using a spray in a washing station of a processing apparatus.
US 3,589,261 applies in a washing station at the entrance a first spray which gives a hard scrubbing action to the surface of the element and at its exit a second spray which gives a light rinsing action to the element.
In US 4,142,194 a rinsing section comprises water impact sprays and barrier means (e.g. a wiper) extending longitudinally of the upper drive roller.
The apparatus "Silverlith", e.g. processor SLT, marketed by Du Pont, comprises a washing section and a rinsing section. In the washing section warm water is dripping out of a tube, without any substantial pressure, on an upper drive roller, which is a scrub roller, as well as on the element. In the rinsing section, water is sprayed on the element which is passed below a squeegee set to remove the water of the element.

The use of common sprays or jets tends to damage the image on the imaging element, or tends to cause clogging of pumps, valves and filters by fragments of the layers removed from the imaging element after its development, both phenomena being detrimental to image quality.

### OBJECT OF THE INVENTION

It is an object of the present disclosure to provide an alternative and improved method for washing lithographic offset printing plates according to the DTR-process.

It is a further object of the present invention to provide an alternative method for obtaining lithographic offset printing plates according to the DTR-process with improved printing properties.

It is a further object of the present invention to provide an alternative apparatus for obtaining lithographic offset printing plates according to the DTR-process with improved printing properties.

Further objects and advantages will become apparent from the description given hereinbelow.

### SUMMARY OF THE INVENTION

According to the present invention, there is provided a method for making an offset printing plate according to the silver salt diffusion transfer process comprising the steps of:
- information-wise exposing an imaging element comprising in the order given (i) a hydrophillic support, (ii) an image receiving layer containing physical development nuclei and (iii) a silver halide emulsion layer;
- developing said information-wise exposed element using an aqueous alkaline processing solution in the presence of at least one developing agent and at least one silver halide solvent to obtain a silver image on said hydrophillic support; and
- removing said silver halide emulsion layer and any optional layer on top of said silver image to uncover said silver image by washing with an aqueous medium,
wherein said washing is carried out by spraying, across the width of the element, a curtain of an aqueous medium onto the surface of the element at its silver halide emulsion layer side, wherein droplets of said aqueous medium impinge on all points of said surface and in counter-current to the processing direction of the element,
characterised in that said spraying is carried out by nozzles which are of a flat spray type having a spray angle α situated between 100° and 150°, in that said spraying is carried out under an inclined angle β between 45° and 80° to the processing path, in that said spraying is carried out under an offset angle γ between 1° and 10° to a transverse to the processing direction of the imaged element, in that the aqueous medium is sprayed with a common pressure at the nozzle ranging from 0.5 bar to 2.0 bar and with a global capacity ranging from 20 litres pro minute to 40 1/min, and in that the temperature of the aqueous medium is between 30°C and 80°C.

According to the present invention, there is also provided an apparatus, comprising a washing station which comprises a washing chamber, two antechambers, a sump or tank for collecting an aqueous medium, entrance and exit roller pairs for transporting an imaged element along a processing path through the station, at least one middle roller arranged for engaging the rear side only of the imaged element, and at least one spraying means comprising nozzles for applying a curtain of an aqueous medium to said element, wherein droplets of said aqueous medium impinge on all points of said surface, said curtain being located between the entrance and the exit transport rollers and being oriented towards the processing path of the element at an inclined angle β to said processing path in a direction counter-current to the processing direction of the element, characterised in that said curtain has an inclined angle β situated between 45° and 80°, in that said nozzles are of a flat spray type having a spray angle α situated between 100° and 150°, in that said nozzles are spaced with an offset angle γ between 1° and 10° to a transverse to the processing direction of the imaged element, and in that the aqueous medium has means for providing a common pressure at the nozzle ranging from 0.5 bar to 2.0 bar and means for providing a global capacity ranging from 20 litres pro minute to 40 l/min.

### BRIEF DESCRIPTION OF THE DRAWINGS

The present invention will be illustrated by means of the following drawings, without however the intention to limit the invention thereto.
Fig. 1 is a schematic longitudinal layout of a processing apparatus suitable for being used with the present invention;
Fig. 2 is a schematic longitudinal layout of a washing station suitable for being used with the present invention;
Fig. 3 is a longitudinal section through a washing station of an apparatus according to the present invention;
Fig. 4 is a transversal section through a washing station of an apparatus according to the present invention;
Fig. 5 gives a survey of producible spray patterns according to prior art;
Fig. 6a gives a principal layout of a spray nozzle according to prior art, and his corresponding spray pattern;
Fig. 6b gives a principal layout of a flat spray nozzle suitable for use with the present invention, and his corresponding spray pattern;
Fig. 7 illustrates the terms "spray angle α" and "theoretical coverage" of a spray nozzle;
Fig. 8a gives a longitudinal side view and Fig. 8b gives a transversal front view of a spray nozzle of a flat spray type;
Fig. 9 gives a perspective view of one embodiment according to the present invention with "offsetted" spray nozzles ;
Fig. 10 gives a transversal front view and an upper view of an embodiment according to Fig. 9;
Fig. 11 gives a transversal front view and an upper view of another embodiment according to the present invention with "intervalled-parallel" rows of spray nozzles.

### DETAILED DESCRIPTION OF THE INVENTION

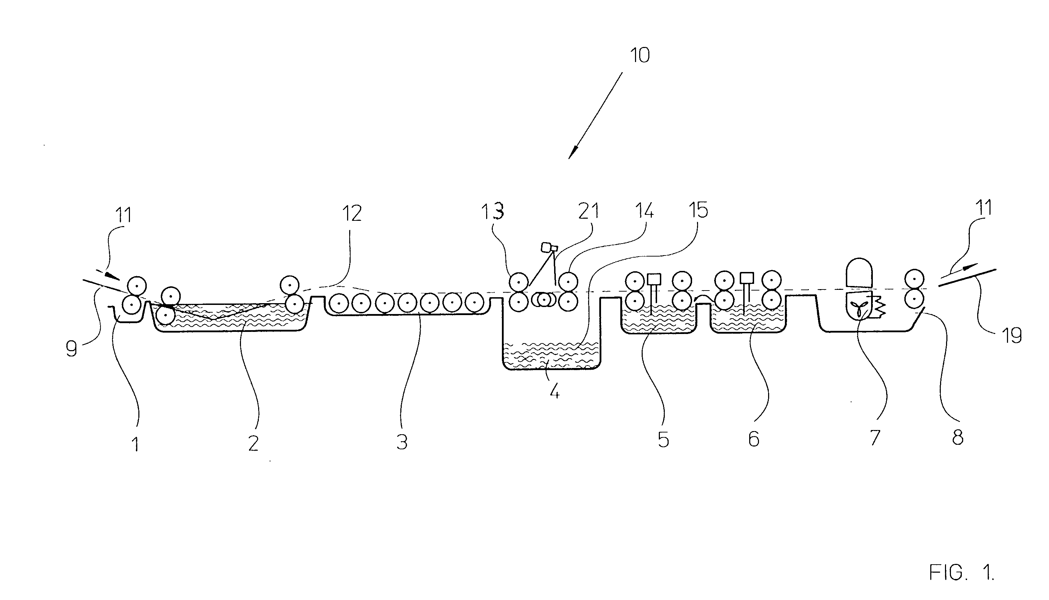

Reference is firstly made to Fig. 1 in which there is illustrated a schematical longitudinal layout through an apparatus 10 for processing exposed printing plates 19 of the type described in EP-0 410 500, said apparatus being suitable for use with the present invention. The apparatus 10 is mounted within a generally rectangular housing (not shown) for supporting the various parts of the apparatus. An informationwise exposed imaged element 9 is progressing in processing direction 11 along a processing path 12 by being sequentially fed through an entrance station 1, a developing station 2, a diffusion transfer station 3, a washing station 4 (to be defined further on) containing a wash-solution 15, a rinsing station 5 and a finishing station 6. After having passed a drying station 7, the printing plate 19 may then leave the apparatus 10 through the output station 8 and a lithographic printing plate 19 is obtained.

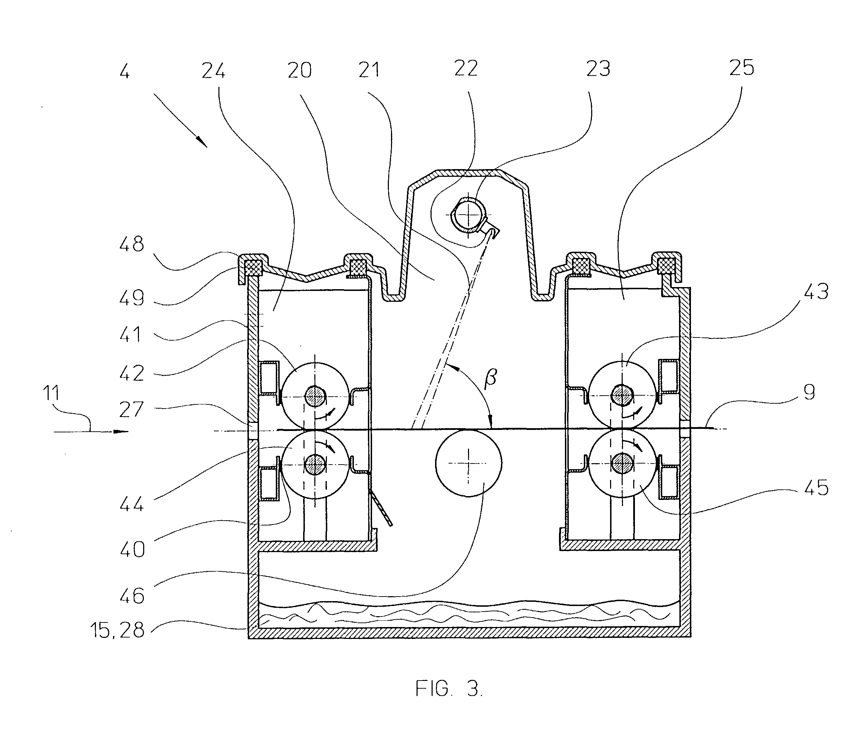

According to an embodiment of uncovering the imaged element, the developed monosheet layer assemblage is washed with an aqueous medium 15 such as water or water with an additive, sometimes also indicated as wash-solution 15 so that the now superfluous emulsion layers are removed from the element. Therefor, in washing station 4, the element is throughputted by an entrance pair 13 of rollers and subsequently washed with a solution 15 which is sprayed onto the surface of the element 9 from a washing nozzle. Washing station 4 also comprises an exit pair 14 of squeegee rollers for squeezing excessive wash-solution 15 from the surface of the element. In the absence of an element, the sprays do not touch neither the entrance nor the exit roller pair, but directly flow into a tank (as can be seen clearly in Fig. 3, which will be explained later on).

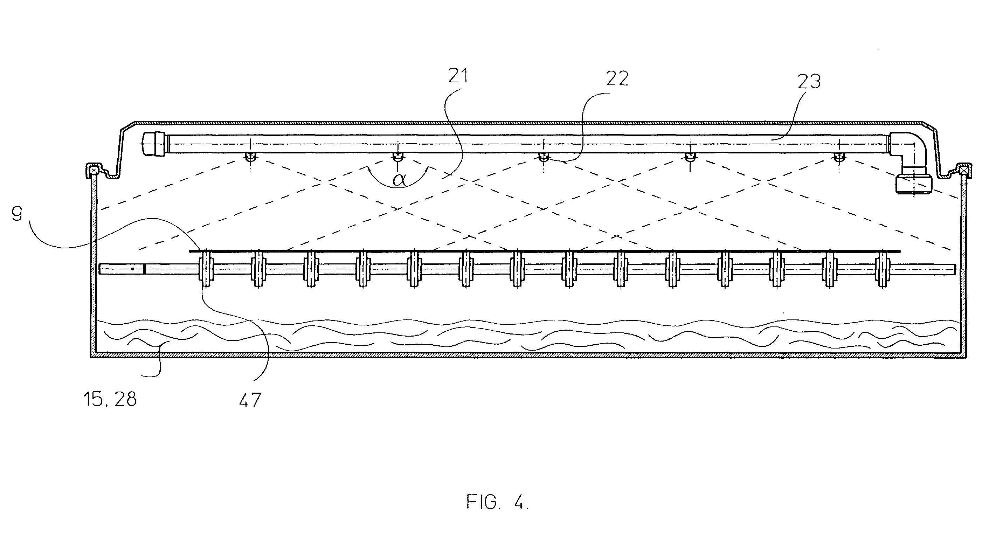

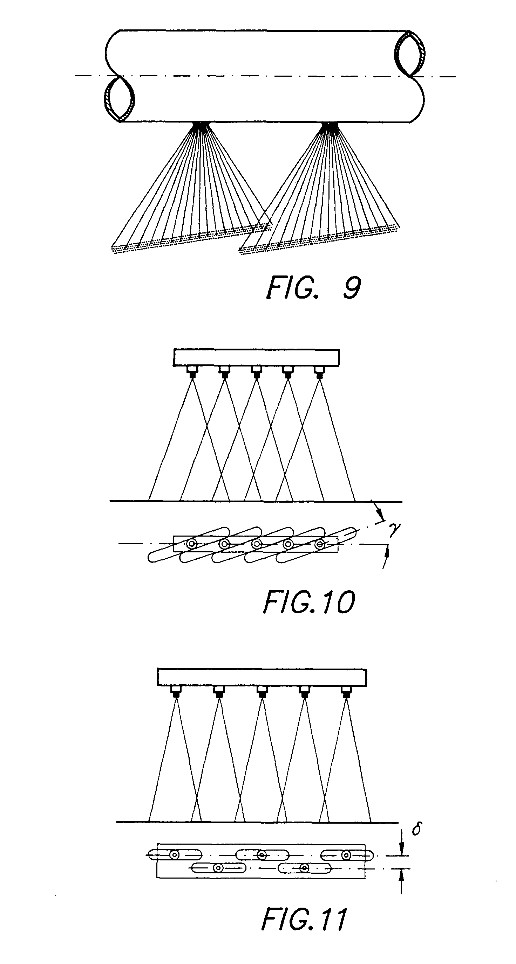

Now, first a description will be given,in reference to Figs. 1-2 and 4 and 10, of the method according to the present invention. In a first preferred embodiment of the present invention, a method for making an offset printing plate (19) according to the silver salt diffusion transfer process comprises the steps of:
- information-wise exposing an imaging element comprising in the order given (i) a hydrophillic support, (ii) an image receiving layer containing physical development nuclei and (iii) a silver halide emulsion layer;
- developing said information-wise exposed element using an aqueous alkaline processing solution in the presence of at least one developing agent and at least one silver halide solvent to obtain a silver image on said hydrophillic
   support; and
- removing said silver halide emulsion layer and any optional layer on top of said silver image to uncover said silver image by washing with an aqueous medium (15; see Fig. 1),
wherein said washing is carried out by spraying, across the width of the element, a curtain of an aqueous medium (15) onto the surface of the element at its silver halide emulsion layer side, wherein droplets of said aqueous medium impinge on all points of said surface and in counter-current (26) to the processing direction (11) of the element, characterised in that said spraying is carried out by nozzles which are of a flat spray type having a spray angle α situated between 100° and 150° (see Fig. 4), in that said spraying is carried out under an inclined angle β (29) between 45° and 80° to the processing path (12; see Fig. 2), in that said spraying is carried out under an offset angle γ between 1° and 10° to a transverse to the processing direction of the imaged element (see Fig. 10), in that the aqueous medium is sprayed with a common pressure at the nozzle ranging from 0.5 bar to 2.0 bar and with a global capacity ranging from 20 litres pro minute to 40 1/min, and in that the temperature of the aqueous medium (15) is between 30°C and 80°C.

In another preferred embodiment of the present invention, said applying of a curtain 21 of an aqueous medium 15 is carried out by spraying while transporting said element through the washing station along a processing path 12, thereby spraying either continuously or discontinuously.

In each embodiment of the present invention, said spraying is carried out under an inclined angle β (referral 29) to the processing path 12 (to be explained later on in the further description; cfr. the later Fig. 3), and the temperature of the aqueous medium 15 is maintained between 30°C and 80° (also to be described later on).

Before starting with the extensive description of the apparatus in full details, it is noticed that e.g. the guidance control of the imaged element in the developing bath is disclosed in our patent application EP-0 623 854; that the squeegee rollers for squeezing excessive aqueous medium 15 from the surface of the element are disclosed in our patent application EP-0 578 869; that two solutions to the problem of rollers adhering together when the processing apparatus is idle are disclosed in our patent applications EP-0 594 895 and EP 0 633 498.

Now reference is made to Fig. 3, which is a longitudinal cross section through a washing station 4 and to Fig. 4, which is a transversal section through a washing station of an apparatus according to the present invention. As it can be seen on these figures 3 - 4, the developed imaging element 9 is passing along processing direction 11 under a spray curtain 21 of aqueous medium 15. The nozzles 22 on the spray heads 23 are preferably designed to ensure that droplets of solution impinge on all points on the surface of the element 9 to ensure an even coverage of the surface and the pressure of the spray curtain 21 is adjusted to ensure that spraying droplets impinge with sufficient impact to wash the element.

As shown in Fig. 3 and in Fig. 4, washing station 4 essentially comprises a washing or spraying chamber 20 and two times an antechamber 24 and 25, one at the incoming side of the spraying chamber and one at the outgoing side of the spraying chamber. More in detail, washing station 4 further advantageously comprises vertical walls 41 with suitable openings 27 for progressing the imaged element 9 into processing direction 11, a sump 28 partly filled with an aqueous medium 15, rubbered upper rollers 42, 43 and rubbered bottom rollers 44, 45 (mounted within the antechamber 24, 25) for gripping and advancing the element 9, one middle roller 46 or several middle rollers 47 which are possibly segmented middle rollers 47, a cover plate 48 and sealing means 49 to prevent solution leakage and air entrainment, as well as associated pump and temperature control means (not shown). Said middle roller 46 (or rollers 47) is (or are) arranged for engaging only the rear side of the element 9.

As a consequence of the preferably very intensive atomization of the droplets, the air within the washing station 4 is highly saturated. By further consequence, the possible danger of leakages of aqueous medium 15 liquid to the preceding (diffusion) station 3 or to the following (rinsing) station 5, is also very high. In order to prevent possible contamination problems, special precautions are to be taken. It is noticed that e.g. sealing means for maintaining a liquid seal 40 between at least one roller of at least one roller pair and an adjacent wall of the washing station is disclosed in our patent application EP-0 633 498.

According to a preferred embodiment of the present invention, an apparatus comprises a washing station 4 which comprises a washing chamber 20, a sump or tank 28 for collecting aqueous medium, entrance and exit rollers 42 to 45 for transporting an imaged element along a processing path 12 through the station, and at least one spraying means for applying a curtain of an aqueous medium 15 to said element, located between the entrance and the exit transport rollers and being oriented towards the silver halide emulsion layer side of said element at an inclined angle β (referral 29) to the processing path 12 in (a direction) countercurrent (referral 26) to the transporting direction 12 of the element.

In another preferred embodiment of the present invention, the washing station further comprises at least one middle roller 46 arranged for engaging the rear side only of the imaged element.

In another preferred embodiment of the present invention, said processing path 12 is substantially horizontal and said spraying means is located above the processing path 12 of the imaged element.

In a further preferred embodiment of the present invention, the washing station 4 comprises a sump or tank 28 provided with an overflow (not shown) for maintaining the aqueous medium 15 at a level below that of the rollers in the station, and with heating means (not shown) for heating the aqueous medium 15. Further, a circulation pump (not shown) draws water from said sump 28 and pumps it to the spray heads 23. An additional pipe (not shown) is fitted to the tank at its lowest point to permit drainage.

In a still further preferred embodiment of the present invention, the washing station 4 additionally comprises a piping connection (not shown) to the water mains supply for optional replenishing fresh wash-water and means (not shown) for dosing an amount of fresh water into tank 28 during replenishment. Upon a signal from e.g. a level detector (not shown) dosing means is controlled to add a certain amount of fresh wash-water into tank.

The apparatus according to the invention comprises in principle no filters in the washing circuit, so that the reliability of operation becomes high. This is different from prior art apparatus operating with an unheated aqueous medium whereby material removed from the imaged element is present in the liquid circuit in the form of skins or flakes which can raise large problems with filtering and/or with spraying.

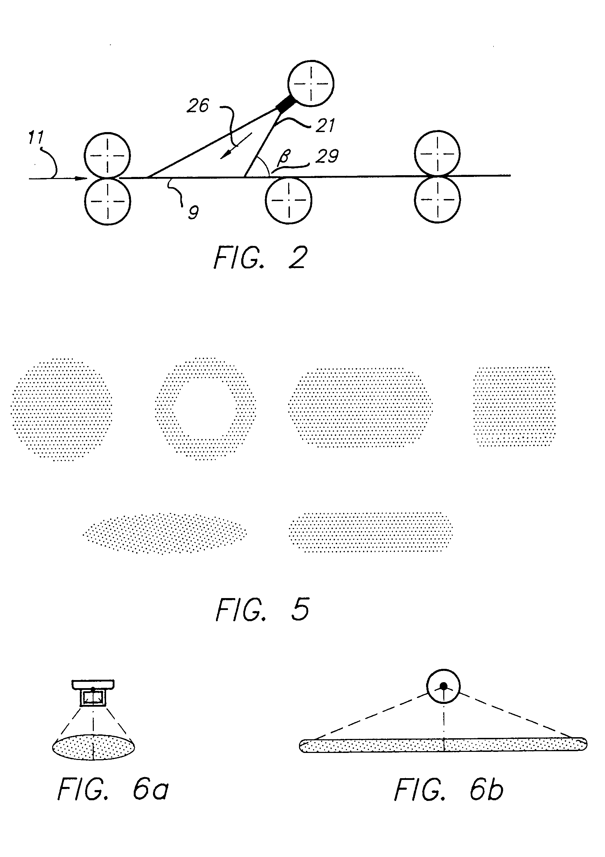

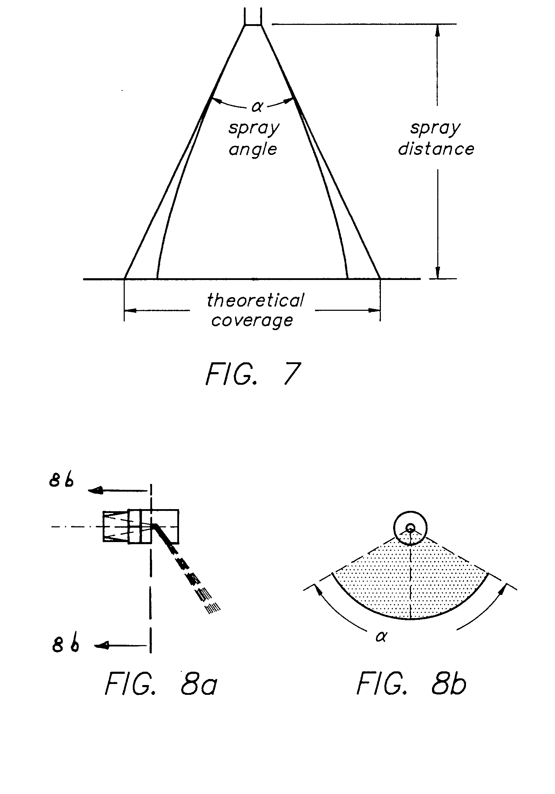

In each embodiment of the present invention, said spraying means are spray nozzles 22. Spray nozzles 22 are usually classified as to the pattern they produce, such as hollow cone, solid cone, flat spray and square spray. Here, reference can be made to Figs. 5, 6 and 7. Herein, fig. 5 gives a survey of some producible spray patterns according to the prior art. Fig. 6 gives a principal layout of two different spray nozzles, each with their corresponding spray pattern; wherein Fig. 6a is a spray nozzle known from prior art, and wherein Fig. 6b is a flat spray nozzle suitable for use with the present invention. Fig. 7 illustrates the term "theoretical coverage" of a spray nozzle.

Whereas the shape of the spray pattern is controlled by the geometry of the nozzle, the output of the spray nozzles 22 depends on the diameter of the nozzle and the hydraulic pressure at the outlet of the nozzle, further indicated as "nozzle pressure".

The size and shape of the spray nozzles and the nozzle pressure are parameters which can be adjusted to ensure an even coverage of the surface of the imaged element 9 and enough force or impact of the spray droplets. The flow rate (or capacity) from the spray nozzles can be accurately controlled by controlling the pressure at the nozzles. This is achieved by using sensitive pressure regulating valves or other devices (not shown for reason of simplicity).

According to the present invention, the nozzles have a spray angle α (defined in Fig. 7 and further indicated in Figs. 4 and 8b) of a spray nozzle situated between 100° and 150° and wherein the spray curtain 21 has an inclined angle β (also indicated with referral 29 and figurated in Figs. 2 and 3) situated between 45° and 80°.

According to the present invention, the aqueous medium 15 is sprayed with a common pressure at the nozzle ranging from 0.5 bar to 2.0 bar and with a global capacity (or total flow) ranging from 20 litres pro minute to 40 l/min.

According to the present invention, the spraying means comprises a plurality of spray nozzles 22 spaced from one another. Herein, the spray nozzles are spaced in at least one single row across the width of the imaged element transverse to the processing direction of the element. This arrangement is particularly suited for obtaining an abundant supply of aqueous medium.

According to the present invention, the nozzles are arranged in a row across the width of the imaged element with an offset angle γ between 1° and 10° to a transverse to the processing direction of the element, thereby producing a plurality of partial spray curtains. Fig. 9 gives a perspective view of one embodiment according to the present invention with "offsetted" spray nozzles, whereas Fig. 10 gives a transversal front view and an upper view of an embodiment according to Fig. 9.

Some of the advantages resulting from using an offset angle γ are that the spray of aqueous medium impinges not only in countercurrent, but also comprises a lateral component, so that the uncovered layer flows away more easily, that no accumulation of wash-water on the imaged element takes place, that no impingement force is reduced by any accumulation of wash-water on the element, and that any interference with adjacent sprays can be avoided.

In another embodiment of the present invention the nozzles are spaced in some "intervalled-but parallel" rows across the width of the imaged element with an offset distance δ between 1 and 15 mm transverse to the processing direction of the element, thereby producing a plurality of partial spray curtains. Fig. 11 gives a transversal front view and an upper view of another embodiment according to the present invention with "intervalled-parallel" rows of spray nozzles.

Therabove, it is important that the rate of application of the aqueous medium 15 be controlled within a predetermined range of flow rates being related to the rate of passage of the imaged element through the apparatus 10.

In a preferred embodiment of the present invention, the spraying means comprises at least one spray nozzle being a nozzle flat spray type (see Figs. 8a and 8b), e.g. Floodjet K12 or K10 or K15, made by Spraying Systems Co., North Avenue at Schmale Road, Wheaton, Illinois - USA.

Another preferred embodiment of the present invention, further comprises recirculation means (not shown) for collecting and recirculating the aqueous medium 15 to the spraying means.

Still another preferred embodiment of the present invention, further comprises a reservoir (not shown) for holding an antibacterium and dosing means for dosing a predetermined amount of said antibacterium into the sump 28 of the washing station 4. Preferably, said antibacterium comprises a liquid with a pH between 10 and 13,5 .

Still another preferred embodiment of the present invention, comprises a developing station 2, a diffusion transfer station 3, a rinsing station 5 and a finishing station 6.

According to the present invention, preferably nozzles with relatively large openings so that there is no risk for the nozzles to become clogged by particles in the aqueous medium 15 that is received from the tank and returned to the spray nozzles.

Using a spray enables successful development of higher resolution images and also offer cost saving advantages because the omission of brushes and wiping rollers not only reduces the initial manufacturing cost but also the maintenance cost.

According to a preferred embodiment of the present invention, a centrifugal pump is used. However, other types of hydraulic pumps might be applied, e.g. piston, membrane, gear or screw type pumps. In selecting the type of pump cost, efficiency, and maintenance generally are the governing factors in making a final selection.

The present invention clearly can be applied in the case of processing materials which are suitable to produce a lithographic offset printing plate by the silver salt diffusion transfer process, but can also be applied in the case of processing other photographic sheet materials.

## Claims

1. A method for making an offset printing plate (19) according to the silver salt diffusion transfer process comprising the steps of:
- information-wise exposing an imaging element comprising in the order given (i) a hydrophillic support, (ii) an image receiving layer containing physical development nuclei and (iii) a silver halide emulsion layer;
- developing said information-wise exposed element using an aqueous alkaline processing solution in the presence of at least one developing agent and at least one silver halide solvent to obtain a silver image on said hydrophillic
support; and
- removing said silver halide emulsion layer and any optional layer on top of said silver image to uncover said silver image by washing with an aqueous medium (15),
wherein said washing is carried out by spraying, across the width of the element, a curtain of an aqueous medium (15) onto the surface of the element at its silver halide emulsion layer side, wherein droplets of said aqueous medium impinge on all points of said surface and in counter-current (26) to the processing direction (11) of the element, **characterised in that** said spraying is carried out by nozzles which are of a flat spray type having a spray angle α situated between 100° and 150°, **in that** said spraying is carried out under an inclined angle β (29) between 45° and 80° to the processing path (12), **in that** said spraying is carried out under an offset angle γ between 1° and 10° to a transverse to the processing direction of the imaged element, **in that** the aqueous medium is sprayed with a common pressure at the nozzle ranging from 0.5 bar to 2.0 bar and with a global capacity ranging from 20 litres pro minute to 40 l/min, and **in that** the temperature of the aqueous medium (15) is between 30°C and 80°C.

2. A method according to claim 1, wherein said spraying is carried out continuously or discontinuously while transporting said element through the washing station along a processing path (12).

3. An apparatus, comprising a washing station (4) which comprises a washing chamber (20), two antechambers (24 and 25), a sump or tank (28) for collecting an aqueous medium, entrance and exit roller pairs (42 to 45) for transporting an imaged element along a processing path through the station, at least one middle roller (46) arranged for engaging the rear side only of the imaged element, and at least one spraying means comprising nozzles for applying a curtain (21) of an aqueous medium to said element, wherein droplets of said aqueous medium impinge on all points of said surface, said curtain being located between the entrance and the exit transport rollers and being oriented towards the processing path (12) of the element (9) at an inclined angle β to said processing path (12) in a direction (26) counter-current to the processing direction (11) of the element, **characterised in that** said curtain (21) has an inclined angle β situated between 45° and 80°, **in that** said nozzles are of a flat spray type having a spray angle α situated between 100° and 150°, **in that** said nozzles are spaced with an offset angle γ between 1° and 10° to a transverse to the processing direction of the imaged element, and **in that** the aqueous medium has means for providing a common pressure at the nozzle ranging from 0.5 bar to 2.0 bar and means for providing a global capacity ranging from 20 litres pro minute to 40 1/min.

4. An apparatus according to claim 3, wherein said processing path is substantially horizontal, wherein said spraying means is located above the processing path of the imaged element, and wherein the nozzles are spaced in at least two intervalled-parallel rows across the width of the imaged element with an offset distance δ between 1 and 15 mm along the processing direction of the element.

5. An apparatus according to claim 3 or 4, wherein said sump or tank comprises an overflow for maintaining the aqueous medium at a level below that of the rollers in the station, replenishing means for replenishing the sump (28) of the washing station (4) with a predetermined amount of fresh wash-liquid, recirculation means for collecting and recirculating the aqueous medium to the spraying means and heating means for heating the aqueous medium.

6. An apparatus according to claim 5, further comprising a reservoir for holding an anti-bacterium and dosing means for dosing a predetermined amount of said anti-bacterium into the sump (28) of the washing station (4), said anti-bacterium comprising a liquid with a pH between 10 and 13,5.

7. An apparatus according to any of the claims 3-6, further comprising a developing station (2), a diffusion transfer station (3), a rinsing station (5) and a finishing station (6).

## Patentansprüche

1. Verfahren zur Herstellung einer Offsetdruckplatte (19) nach dem Silbersalz-Diffusionsübertragungsverfahren, das die folgenden Schritten umfasst :
- informationsmäßiges Belichten eines Bild erzeugenden Elements, das der angegebenen Reihe nach (i) einen hydrophilen Träger, (ii) eine physikalische Entwicklungskeime enthaltende Bildempfangsschicht und (iii) eine Silberhalogenid-Emulsionsschicht umfasst;
- Entwickeln des informationsmäßig belichteten Elements unter Verwendung einer alkalischen Behandlungslösung in Gegenwart einer oder mehreren Entwicklersubstanzen und eines oder mehrerer Silberhalogenid-Lösungsmittel, wobei auf dem hydrophilen Träger ein Silberbild erhalten wird; und
- Entfernen der Silberhalogenid-Emulsionsschicht sowie jeder eventuellen über dem Silberbild befindlichen Schicht, durch Waschen mit einem wässrigen Medium (15), wobei das Silberbild freigelegt wird,
wobei das Waschen dadurch erfolgt, dass ein Vorhang eines wässrigen Mediums (15) auf die Oberfläche des Elements an dessen Silberhalogenid-Emulsionsschichtseite quer über die Breite des Elements gespritzt wird, wobei Tröpfchen des wässrigen Mediums auf alle Punkten dieser Oberfläche und im Gegenstrom (26) zu der Behandlungsrichtung (11) des Elements auftreffen, **dadurch gekennzeichnet, dass** das Bespritzen unter Verwendung von Düsen von einem Flachspritztyp mit einem Spritzwinkel α im Bereich von 100° bis 150° durchgeführt wird; dadurch, dass das Bespritzen um einen Winkel β (29) zwischen 45° und 80° geneigt zur Behandlungsstrecke (12) durchgeführt wird; dadurch, dass das Bespritzen um einen Winkel γ zwischen 1° und 10° versetzt zur Queren, bezogen auf die Behandlungsrichtung des bebilderten Elements, durchgeführt wird; dadurch, dass das wässrige Medium bei einem gängigen Druck an der Düse im Bereich von 0,5 bar bis 2,0 bar und bei einer gesamten Durchflußmenge im Bereich von 20 ℓ/min bis 40 ℓ/min gespritzt wird, und dadurch, dass die Temperatur des wässrigen Mediums (15) im Bereich von 30°C bis 80°C liegt.

2. Verfahren nach Anspruch 1, **dadurch gekennzeichnet, dass** das Bespritzen ununterbrochen oder unterbrochen durchgeführt wird, während das Element durch die Waschstation längs einer Behandlungsstrecke (12) gefördert wird.

3. Gerät mit einer Waschstation (4), die eine Waschkammer (20), zwei Vorkammern (24 und 25), einen Sumpf bzw. eine Wanne (28) zum Auffangen eines wässrigen Mediums, Eintritts- und Austrittswalzenpaaren (42 bis 45) zum Fördern eines bebilderten Elements längs einer Behandlungsstrecke durch die Station, wenigstens eine nur zum Greifen der Rückseite des bebilderten Elements angeordnete mittlere Walze (46), und wenigstens ein Spritzmittel mit Düsen zum Auftragen eines Vorhangs (21) aus einem wässrigen Medium auf das Element umfasst, wobei Tröpfchen des wässrigen Mediums auf alle Punkte dieser Oberfläche auftreffen,
wobei sich der Vorhang zwischen den Eintritts- und Austrittsförderwalzen befindet und der Behandlungsstrecke (12) des Elements (9) um einen Winkel β geneigt zur Behandlungsstrecke (12) in einer Richtung (26) im Gegenstrom zur Behandlungsrichtung (11) des Elements zugekehrt ist, **dadurch gekennzeichnet, dass** der Vorhang (21) einen geneigten Winkel β im Bereich von 45° bis 80° aufweist, dadurch, dass die Düsen von einem Flachspritztyp mit einem Spritzwinkel α im Bereich von 100° bis 150° sind, dadurch, dass die Düsen mit Zwischenraum um einen Winkel γ zwischen 1° und 10° versetzt zur Queren, bezogen auf die Behandlungsrichtung des bebilderten Elements, angeordnet sind , und dadurch, dass das wässrige Medium Mittel zur Bereitstellung eines gängigen Drucks an der Düse im Bereich von 0,5 bar bis 2,0 bar und Mittel zur Bereitstellung einer gesamten Durchflußmenge im Bereich von 20 ℓ/min bis 40 ℓ/min aufweist.

4. Gerät nach Anspruch 3, **dadurch gekennzeichnet, dass** die Behandlungsstrecke im wesentlichen horizontal läuft, dadurch, dass sich das Spritzmittel über der Behandlungsstrecke des bebilderten Elements befindet, und dadurch, dass die Düsen mit Zwischenraum in wenigstens zwei mit Zwischenraum parallel angeordneten Reihen quer über die Breite des bebilderten Elements in einem Abstand δ zwischen 1 und 15 mm versetzt längs der Behandlungsrichtung des Elements angeordnet sind.

5. Gerät nach Anspruch 3 oder 4, **dadurch gekennzeichnet, dass** der Sumpf bzw. die Wanne einen Überlauf, mit dem das wässrige Medium auf einem Füllstand unter dem Niveau der Walzen in der Station gehalten wird, Regeneriermittel, mit denen der Sumpf (28) der Waschstation (4) mit einer vorgegebenen Menge an frischem Waschflüssigkeit nachgefüllt wird, Zurückführmittel, mit denen das wässrige Medium aufgefangen und den Bespritzungsmitteln zurückgeführt wird und Heizmittel zum Heizen des wässrigen Mediums umfasst.

6. Gerät nach Anspruch 5, das weiterhin einen Vorratsbehälter für ein antibakterielles Mittel sowie Dosiermittel, mit denen eine vorgegebenen Menge dieses antibakteriellen Mittels in den Sumpf (28) der Waschstation (4) dosiert wird, umfasst, wobei das antibakterielle Mittel eine Flüssigkeit mit einem pH-Wert von 10 bis 13,5 enthält.

7. Gerät nach einem der Ansprüche 3-6, das weiterhin eine Entwickelstation (2), eine Diffusionsübertragungsstation (3), eine Spülstation (5) und eine Schlußbehandlungsstation (6) umfasst.

## Revendications

1. Procédé de confection pour une plaque d'impression offset (19) conformément au procédé de transfert de sels d'argent par diffusion, comprenant les étapes consistant à:
- exposer en forme d'information un élément formateur d'images comprenant dans l'ordre indiqué (i) un support hydrophile, (ii) une couche réceptrice d'images contenant des germes de développement physique et (iii) une couche d'émulsion aux halogénures d'argent
- développer ledit élément exposé en forme d'information en utilisant une solution de traitement alcaline en présence d'un ou de plusieurs agents développateurs et d'un ou de plusieurs solvants des halogénures d'argent afin d'obtenir une image argentique sur ledit support hydrophile; et
- enlever ladite couche d'émulsion aux halogénures d'argent ainsi que toute couche éventuelle déposée au-dessus de ladite image argentique, afin de mettre à découvert ladite image argentique par lavage à l'aide d'un véhicule aqueux (15),
ledit lavage s'effectuant en arrosant un rideau d'un véhicule aqueux (15) à travers la largeur de l'élément sur la surface de l'élément du côté de sa couche d'émulsion aux halogénures d'argent, tous les points de ladite surface étant atteints par des gouttelettes dudit véhicule aqueux à contre-courant (26) par rapport au sens de traitement (11) dudit élément, **caractérisé en ce que** ledit arrosage s'effectue au moyen de buses qui sont d'un type d'arrosage aplati possédant un angle d'arrosage α compris entre 100° et 150°, **en ce que** ledit arrosage s'effectue avec un angle d'inclinaison β (29) de 45° à 80° par rapport à la trajectoire de traitement (12), **en ce que** ledit arrosage s'effectue avec un angle de décalage γ de 1° à 10° par rapport à un axe transverse relativement au sens de traitement de l'élément muni d'une image, **en ce que** le véhicule aqueux est arrosé avec une pression habituelle à la buse variant entre 0,5 bar et 2,0 bar et avec un débit global variant entre 20 ℓ/min. et 40 ℓ/min., et **en ce que** la température du véhicule aqueux (15) est comprise entre 30°C et 80°C.

2. Procédé selon la revendication 1, **caractérisé en ce que** ledit arrosage s'effectue de façon continue ou discontinue pendant que ledit élément est transporté à travers le poste de lavage le long d'une trajectoire de traitement (12).

3. Dispositif avec un poste de lavage (4) comportant une chambre de lavage (20), deux antichambres (24 et 25), un puisard ou une cuve (28) destiné resp. destinée à capter un véhicule aqueux, des paires de rouleaux d'entrée et de sortie (42 à 45) destinées à transporter un élément muni d'une image le long d'une trajectoire de traitement à travers le poste, au moins un rouleau central (46) agencé pour ne saisir que le verso de l'élément muni d'une image, et au moins un moyen d'arrosage comportant des buses destinées à appliquer un rideau (21) d'un véhicule aqueux sur ledit élément, tous les points de ladite surface étant atteints par des gouttelettes dudit véhicule aqueux, ledit rideau étant disposé en un emplacement situé entre les rouleaux transporteurs d'entrée et de sortie et étant orienté vers la trajectoire de traitement (12) dudit élément (9) avec un angle d'inclinaison β par rapport à la trajectoire de traitement (12) dans un sens (26) à contre-courant par rapport au sens de traitement (11) dudit élément, **caractérisé en ce que** ledit rideau (21) possède un angle d'inclinaison β compris entre 45° et 80°, **en ce que** lesdites buses sont d'un type d'arrosage aplati possédant un angle d'arrosage α compris entre 100° et 150°, **en ce que** lesdites buses sont écartées d'un angle de décalage γ de 1° à 10° par rapport à un axe transverse relativement au sens de traitement de l'élément muni d'une image, et **en ce que** le véhicule aqueux possède des moyens destinés à procurer une pression habituelle variant entre 0,5 bar et 2,0 bar et des moyens destinés à procurer un débit global variant entre 20 ℓ/min. et 40 ℓ/min.

4. Dispositif selon la revendication 3, **caractérisé en ce que** ladite trajectoire de traitement est essentiellement horizontale, **en ce que** ledit moyen d'arrosage est disposé en un emplacement au-dessus de la trajectoire de traitement de l'élément muni d'une image, et **en ce que** les buses sont écartées sur au moins deux rangées parallèles à intervalles à travers la largeur de l'élément muni d'une image avec une distance de décalage δ de 1 à 15 mm le long du sens de traitement de l'élément.

5. Dispositif selon la revendication 3 ou 4, **caractérisé en ce que** ledit puisard resp. ladite cuve comporte un trop-plein destiné à maintenir le véhicule aqueux à un niveau inférieur au niveau des rouleaux dans le poste, des moyens de régénération destinés à compléter le puisard (28) du poste de lavage (4) avec une quantité prédéfinie de liquide de lavage frais, des moyens de recirculation destinés à capter et remettre le véhicule aqueux en circulation vers les moyens d'arrosage et des moyens de chauffage destinés à chauffer le véhicule aqueux.

6. Dispositif selon la revendication 5, comportant en outre un réservoir destiné à contenir un agent antibactérien et des moyens de dosage destinés à doser une quantité prédéfinie dudit agent antibactérien dans le puisard (28) du poste de lavage (4), ledit agent antibactérien comprenant un liquide dont le pH est compris entre 10 et 13,5.

7. Dispositif selon l'une quelconque des revendications 3-6, comportant en outre un poste de développement (2), un poste de transfert par diffusion (3), un poste de rinçage (5) et un poste de finition (6).
